Europäisches Patentamt

European Patent Office

Office européen des brevets

(19)

(11) Publication number: **0 353 331**

**A1**

(12) **EUROPEAN PATENT APPLICATION**

(21) Application number: **88112774.0**

(22) Date of filing: **05.08.88**

(51) Int. Cl.⁴: **G07C 5/10 , G01R 31/00**

(43) Date of publication of application:
**07.02.90 Bulletin 90/06**

(84) Designated Contracting States:
**DE FR IT SE**

(71) Applicant: **ROBERT BOSCH GMBH**
**Postfach 10 60 50**
**D-7000 Stuttgart 10(DE)**

(72) Inventor: **Denz, Helmut**
**Augustenstrasse 41**
**D-7000 Stuttgart 1(DE)**
Inventor: **Margarit-Metaxa, Florin**
**Hummelsbüttler Hauptstrasse**
**D-2000 Hamburg 63(DE)**

(54) **Fault finding system with selective interactive communication.**

(57) A vehicle control system includes at least one electronic control unit (ECU1...ECUn) which has means for detecting a fault within the unit (ECU1...ECUn) itself and/or any actuators associated therewith, and means for illuminating a warning lamp (F1...Fn) in response to fault detection. The system includes means for interrogating the control unit (ECU1...ECUn), for example to detect the nature of a fault, whose operation may be initiated by depressing a manually controlled switch (SW1). A light, e.g. the warning lamp itself (F1...Fn), flashes in a coded sequence to "talk back" to the user.

FIG.2.

EP 0 353 331 A1

## Fault Finding System with Selective Interactive Communications

The present invention relates to a fault finding system for use with electronic circuitry associated with vehicles.

Modern vehicles are provided with one or more electronic control units each with a microprocessor. Normally the control units are interconnected by a bus so that they can interchange information as necessary. As an example, it is known to provide a motor vehicle with three electronic control units, one for engine management, one for automatic gear shift control and one for automatic brake control. Further, it is customary for warning lights to be present in the vehicle to warn the driver of any potentially dangerous fault so that he can either stop the vehicle or else have the vehicle attended to in a garage as soon as possible. Each electronic control unit can be associated with a separate warning lamp or certain electronic control units may actually share a single warning lamp.

Modern electronic control units are designed to monitor both themselves and the sensors and actuators associated therewith and to not only illuminate a warning light should they detect the fault but also store an indication of the fault in a random access memory which can be interrogated at a later stage by special test equipment. One arrangement for carrying out the process described above is disclosed in German specification 3511968 where the electronic control unit generates a fault code which is stored in a memory but is also used to illuminate a warning lamp. However, the fault code in the form of digital pulses is transmitted at such a rate that any flickering of the lamp is not detectable to the naked eye and so a driver simply notices that the warning light is illuminated.

While this system is extremely efficient and enables a mechanic to quickly locate and correct a fault, it does require a substantial investment in terms of test equipment. Further, the test equipment is usually designed to carry out a complete test on all electronic control units which can occupy a considerable amount of time. A need, therefore, exists to provide a vehicle control system which enables the electronic control units fitted in the vehicle to be interrogated without the need for special test equipment.

The present invention provides an electronic system for controlling the operation of a vehicle including at least one electronic control unit (ECU) connected to at least one actuator or sensor, the system being arranged to carry out a plurality of tests for indicating faults in parts of the system, characterised by manually operable switch means for providing a signal indicative of a requested test and visual display means for providing a visual indication to confirm the test requested.

A test may simply involve polling the or each ECU to ensure that it is operational. Alternatively a test may comprise several stages such as a single ECU carrying out checks on several activators or sensors with which it it associated. In certain cases a test may involve examining the memory of a ECU for stored faults.

The control system does not require any hardware changes or additions other than provision of the manually operable switch means. Further, it allows undelayed addressing of the or each control unit for diagnosis.

Preferably the system includes a plurality of ECUs each connected to said visual display means and to at least one actuator or sensor and each arranged to operate in at least one operating mode for detecting a fault within the unit and/or said at least one actuator or sensor and the switch means is operable to address a selected ECU and the visual display means operates to indicate which ECU has been selected.

Thus, for example the user may input a certain number of pulses to select a particular control unit to be diagnosed. To achieve this the system must be able to recognise pulses within a very coarse time frame. The or each ECU may be arranged to operate in a plurality of operating modes for detecting a fault within the unit and/or said at least one actuator or sensor, and the switch means may be operable to select a particular operating mode with the visual display means operating to indicate which operating mode has been selected.

With this arrangement the user may input a certain number of pulses via the switch means to select a particular operating mode.

It is possible in accordance with this invention. to enable the sequence of steps within individual operating modes to be selectable via the switch means. However it is preferred that the individual steps are carried out in a predetermined sequence to simply the coding structure required.

Preferably the visual display means comprise a lamp arranged to flash in a coded sequence indicative of the selected test. Thus the sequence may indicate the selected ECU and/or the selected operating mode.

Although the system is designed to provide a simple easily addressable diagnostic system requiring no special test equipment, it is still possible to couple the system to a test terminal to provide more quantitative information regarding the tests.

2

The visual display means may be arranged to indicate the presence of certain faults during running of the engine while no test is being carried out. In other words, the visual display means may be the warning lamp which is often provided on the vehicle dashboard for indicating certain critical faults such as the brake pads having warn out or the oil level being dangerously low or, as is now required on certain U.S. vehicles, faults affecting the exhaust gas composition.

A preferred embodiment of the invention will now be described by way of example only and with reference to the accompanying drawings of which:

Figure 1 is a flowchart illustrating the operation of the vehicle control system during normal operation of the vehicle;

Figure 2 is a block diagram of a first embodiment of vehicle control system according to the present invention;

Figure 3 is a block diagram of a second embodiment of vehicle control system according to the present invention;

Figure 4 is a diagram showing the hierarchy of the diagnostic system of the vehicle control system;

Figure 5 is a timing pattern illustrating possible manual inputs to the diagnostic system;

Figure 6 illustrates the fault lamp flashing code at various times during a diagnostic sequence;

Figure 7 illustrates a typical flashing code output for a first mode of operation of the diagnostic system;

Figure 8 is a step by step timing chart for the first mode of operation;

Figure 9 is a timing waveform illustrating lamda regulation in the first mode;

Figure 10 is a step by step timing chart for second mode of operation of the diagnostic system;

Figure 11 is a chart illustrating sensor testing in the second mode;

Figure 12 is a step by step timing chart for a third mode mode of operation of the diagnostic system; and

Figure 13 is a step by step timing chart for the fourth mode.

The embodiment of the invention described below is a vehicle control system having a simple self diagnostic system.

During normal operation of the engine a fault lamp (engine check lamp) or a digital display informs the driver about the occurrence of faults which can be evaluated at a later stage by experienced personnel using the self-diagnostic. Such faults include faults which are critical from the point of view of safety or faults which are prescribed to be displayed by law. For example, a new law passed in California requires all 1988 and subsequent cars to include means for informing the driver about faults which affect the exhaust gas composition.

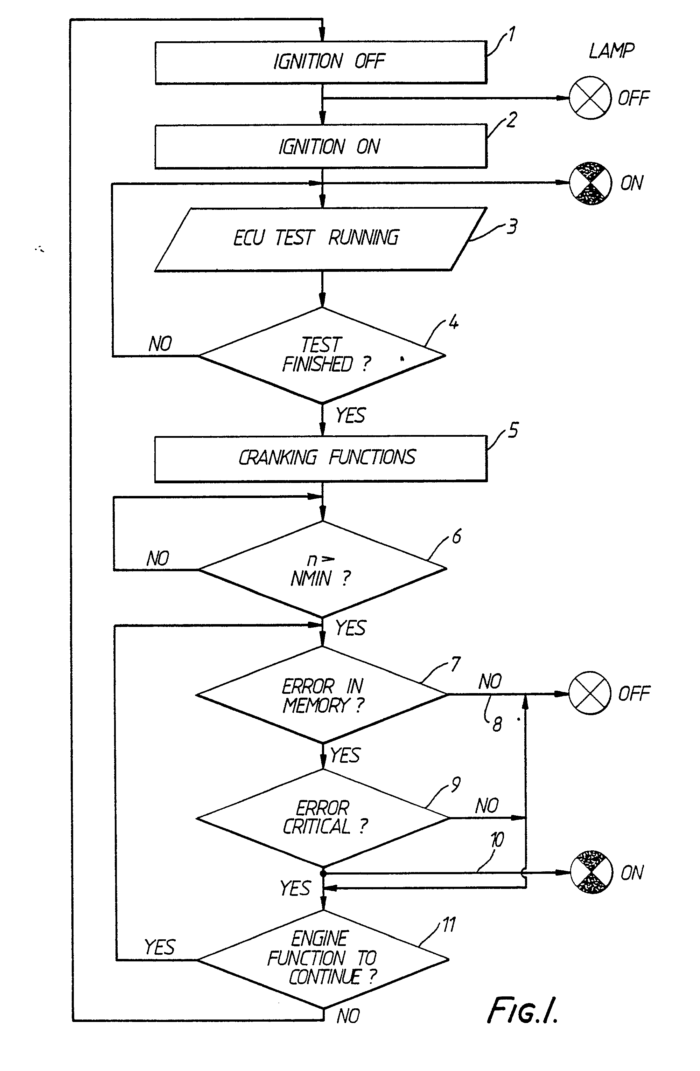

Figure 1 is a flow chart illustrating the operation of a control unit and its associated fault lamp during cranking and running of an engine. The particular control unit illustrated controls injection and ignition of the engine and includes a fault memory in which detected faults are stored. After the engine ignition has been switched on using the ignition key and during cranking, i.e. while the engine is turning at a speed less than a predetermined speed, the fault lamp is switched ON by the ECU. As indicated in Figure 1, the fault lamp is switched on after the "ignition ON" step 2 has been carried out (by the driver turning the the ignition key). Before cranking the engine carries out a self check, indicated at steps 3 and 4. Cranking functions at step 5 are not carried out until this process has been completed. A step 6 the rotational speed n is checked. If n is greater than the predetermined speed mentioned above, indicating that the engine is no longer cranking, the system proceeds to interrogate the fault memory.

If there is an error in the memory and it is critical, the lamp is switched on, otherwise it is switched off. This is indicated at steps 7 to 10 in the flowchart. During the continuing function of the engine (at step 11) the memory is checked again for errors and the lamp is switched on or left off accordingly.

If the engine function is not to continue, i.e. the ignition key has been turned off or the engine has stalled, the process is simply started again from step 1 next time the ignition key is switched on.

The engine control system may include a plurality of ECUs each with a respective fault lamp for indicating various faults. Alternatively, one fault lamp may be shared by more than one ECU to indicate several faults. Further, the fault lamp may be replaced by a display unit such as an alpha-numeric display unit or a digital display unit.

Any fault which occurs for longer than a system-specific delay, is stored in the fault memory of the control device. Thus, the memory stores short-lived critical fault indications, which may occur due to some fault in the sensing equipment, as well as non-critical faults which do not cause the lamp to be illuminated.

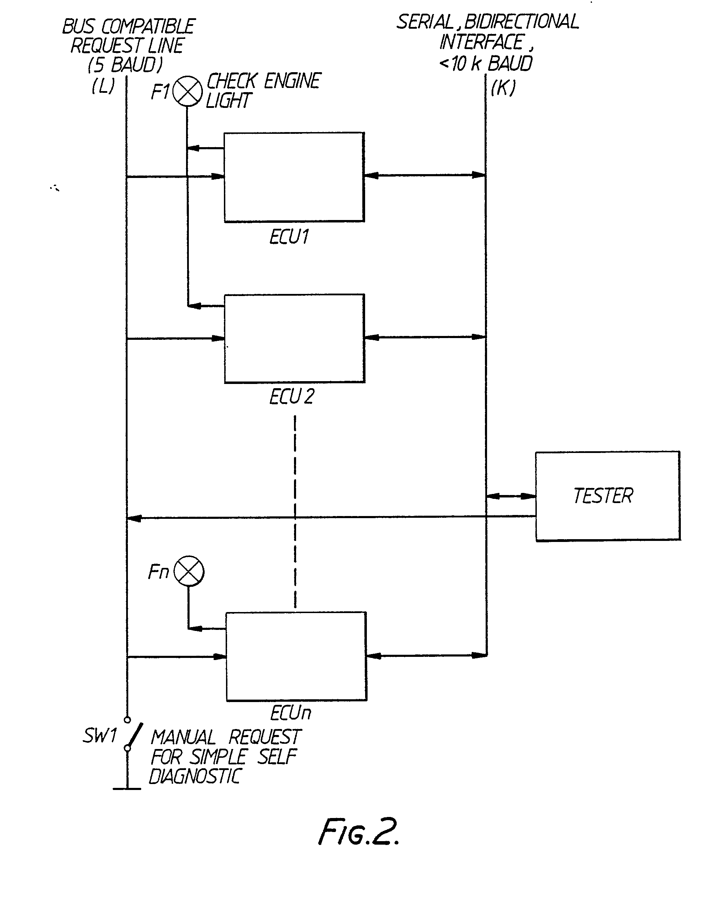

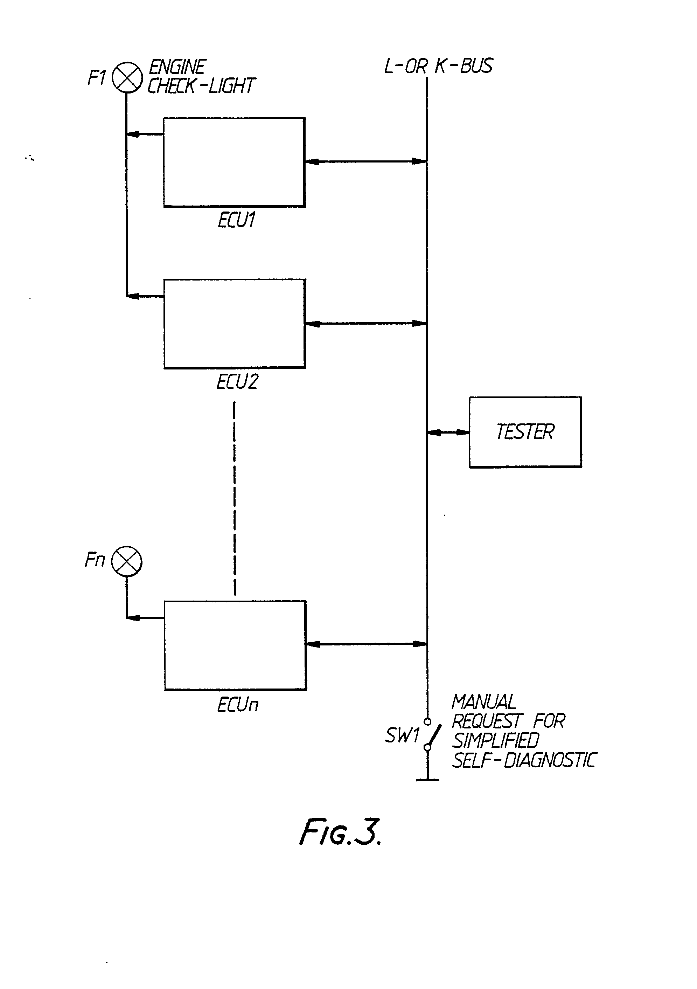

The self-diagnostic described below is specifically intended for bus-capable systems. Two examples of such systems are illustrated in Figs.2 and 3.

In the arrangement shown in Fig. 2 several electronic control units or control devices ECU1, ECU2....ECUn are connected to a common address line L and a common data communication line K. Each of the control devices is connected to a fault lamp F. All of the control devices may be connected to the same lamp F so that one lamp is used to indicate the fualts of all ECUs as mentioned above. However, in the arrangement shown in Fig. 2 or 3, more than one fault lamp F is provided. Thus, for example, one fault lamp F might indicate faults in the engine management control unit and the automatic gear shift control whilst another, Fn, indicates separately faults in the automatic brake control unit.

Figure 2 shows a bus system with a bidirectional serial data bus K between a tester and the ECUs the data line being operable at any data rate <10K Baud. A separate unidirectional address bus L interconnects the ECUs and the tester. The address bus L is connected to a reference potential such as ground through a manually operable switch.

Figure 3 illustrates an alternative arrangement to that shown in Figure 2. In this arrangement there is a single address/data bus K which is used for addressing and communicating with the control devices.

During normal operation each control unit operates in the manner illustrated in Fig. 1. A request for simple selfdiagnostic information is made via a manually operable switch SW1. Operation of the switch in a specified manner, to be described below, causes the initialization process for the simple selfdiagnostic to be carried out.

In the arrangement of Fig. 2, the manually operable switch operates to connect the L bus to ground. In the arrangement of Fig. 3, the manually operable switch operates to connect the K-bus to ground. The electronic ocntrol units are arranged to respond to manually input pulses received in the switch SW1, and to output pulses which are visible to the naked eye via their respective fault lamps to provide qualitative information on the faults. Thus, the fault lamp is not only designated to warn the driver, but also to output diagnostic information. In practice, the manual switch may be provided under the dashboard of the vehicle, for example, to be used only by experienced personnel. Additionally or alternatively, the manual switch may be located in the engine compartment in which case it is useful to have a terminal to connect an additional lamp or lamps in the engine compartment also but electrically in parallel with the fault lamp or lamps in the passenger compartment. As before, the lamp or lamps in the engine compartment could be replaced by an alpha-numeric or digital display. The location of the additional switch and lamp/display in the engine compartment may vary from car to car but is most conve niently near the connector for connecting the engine to the tester.

The code output via the lamp provides a simple selfdiagnostic without the need for sophisticated test equipment. However, with either of the illustrated systems the possibility still remains of connecting test equipment, as shown in Fig. 2 or Fig. 3 for gathering more detailed information than is available through the lamp flashing sequence.

In the most flexible diagnostic system the control devices can be addressed selectively and the actual test mode of a control device can also be selected by the tester.

There now follows a detailed description to illustrate how a typical simple selfdiagnostic for an engine control system may be implemented in accordance with the invention.

The simple selfdiagnostic is initiated by manually making connections between the K or L bus and ground (logic "O" active); the duration of the ground link is determining for the further progress of the diagnostic. Interruptions and returns are possible at any time due to the modular configuration which enables the diagnostic time to be considerably reduced.

The components (modules) of the diagnostic are:

    a) Initialization
    b) ECU selection
    c) Mode selection
    d) Arrangement within a mode

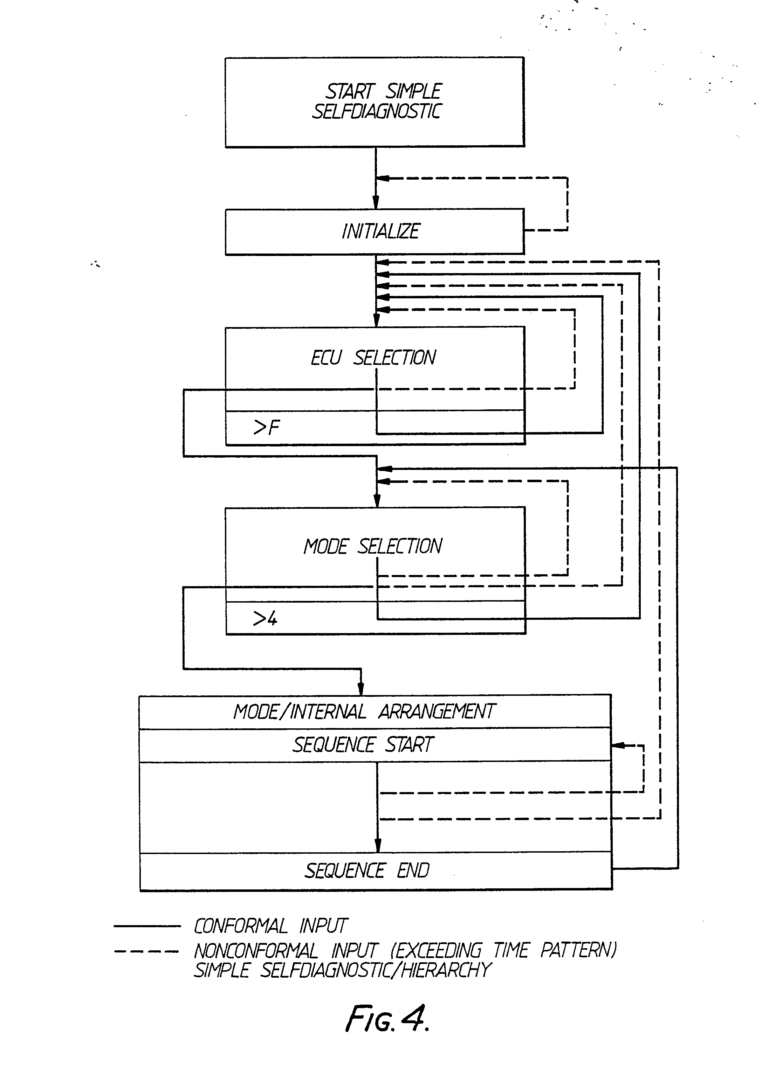

The hierarchy of the arrangement is shown in Figure 4.

a) Initialization:

All ECUs connected to the input bus are initialized when the K or L bus is connected to ground for $t_{INIT}$ > 2 sec. (logic "O">2.0 sec.); after the ground connection is interrupted, the input is blocked for $t_{RW1}$ > 0.3 sec. (reliable progression of the initialization process).

Initialization can only take place when the ignition is on and the engine is at a standstill or idling.

4

Output (via the fault lamp):

Lamp off (an initialization flashing code has been deliberately omitted to maintain the concept of equality for individual ECUs).

ECU Selection:

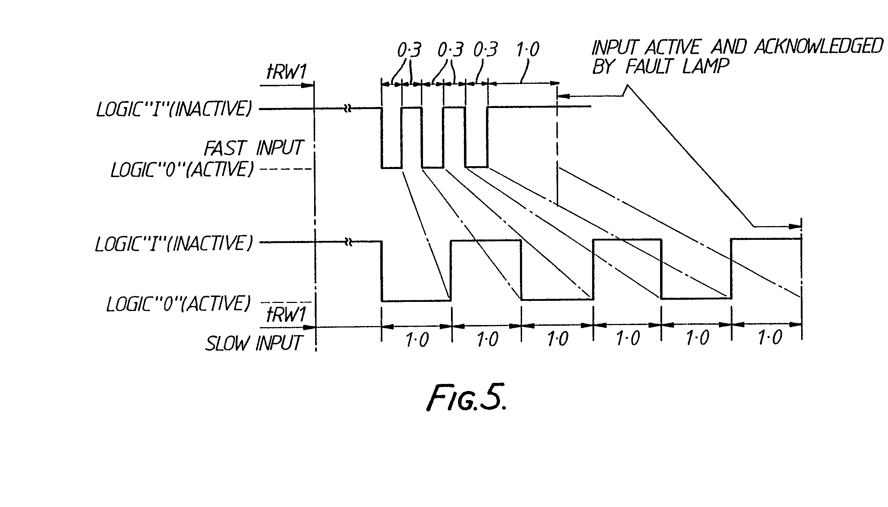

After initialization, ECU selection is achieved by a series of manually input pulses between the K or L bus and ground. The number of pulses identifies the particular ECU to be selected. Because the pulses are manually input the system must be able to recognise pulses in a coarse time pattern (see Fig. 5). In this embodiment the system recognises pulses as conformal inputs if the logic "O" or logic "I" duration is 0.3 to 1.0 sec. The fault lamp is used as a acknowledgement for simplifying the input. Nonconformal inputs (outside the time pattern) and their consequences can be summarised as follows:
- logic "O" < 0.3 sec. → repeat input/fault lamp off
- logic "O" > 1.0 sec. → repeat input/fault lamp off
- logic "I" < 0.3 sec. → repeat input/fault lamp off
- logic "O" > 2.0 sec. → initialization/fault lamp off
The effects of nonconformal inputs are illustrated in Fig. 4. As shown, following a nonconformal input the system simply reverts to the previous step.

TheECU selection is selective (the number of logical "O" pulses corresponds to the ECU address). The input pulses are added together: when a "1"→"0" transition arrives which fits into the time pattern, the ECU having the same address as sub-total is switched off, when a "0"→"1" transition arrives which fits into the time pattern, the sum (the last sub-total) is incremented. The occurrence of an interval period (logic "1") > 1.0 sec. is recognised as the conclusion of the input. The sub-total is activated as final total and the ECU's whose address is greater than the final total are also switched off.

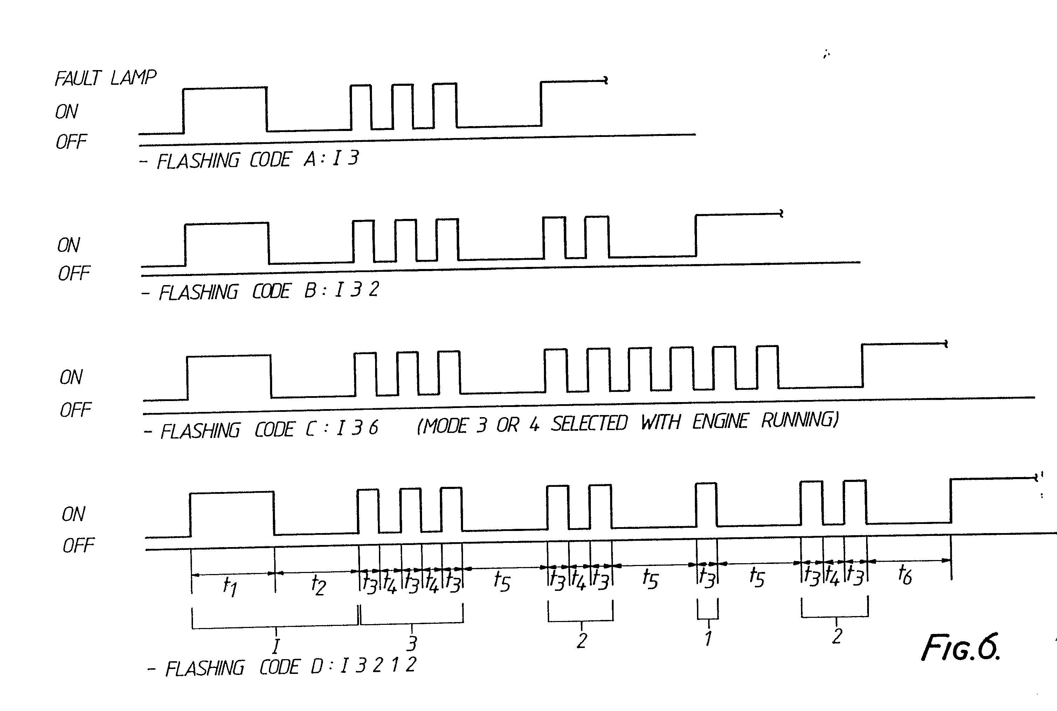

The selectedECU acknowledges the successful input by flashing code A via the fault lamp (see Fig. 6 - ExampleECU No. 3).

After interruption of the last ground connection, the input is blocked for $t_{RW2} \geq 1.5$ sec. (reliable progression of the ECU selection process).

Note:

If no acknowledgement by the corresponding ECU (flashing code via the fault lamp) occurs after theECU address input, this means that:
- the input is incorrect
- this ECU does not exist
- this ECU is defective
In Fig. 4, F indicates the highest ECU address. If the input address is greater than F the system reverts back to the ECU select step as shown.

The flashing codes shown in Figure 6 are each repeated indefinitely until the next call is received via the manual switch.

c) Mode selection:

Mode selection occurs in the same manner as the ECU selection by entering the corresponding number of "0" pulses (modes 1-4 are permitted in the present embodiment; other modes are possible, for example for outputting the variant coding etc.).

The successful input (activated after the first logical "1" signal > 1.0 sec after a current input sequence) is acknowledged with flashing code B via the fault lamp (see Fig. 6 - Example ECU No. 3, mode 2).

Nonconformal inputs (exceeding the time pattern) and their consequences can be summarised as follows:
- logic "0" < 0.3 sec. → repeat input/flashing code A
- logic "0" > 1.0 sec.→ repeat input/flashing code A
- logic "1" < 0.3 sec. → repeat input/flashing code A
- logic "0" > 2.0 sec. → initialisation/fault lamp off

After the last ground connection has been interrupted, the input is blocked for $t_{RW2} \geq 1.5$ sec. (reliable progression of the mode selection process).

As shown in Fig. 4, if a mode code greater than 4 is inadvertently selected the system simply reverts to the CD select step.

Restriction:

When the engine is running, only mode 1 and 2 are permissible; if mode 3 or mode 4 is selected, flashing code C fault signal occurs (see Fig. 6 in which code 6 indicates an impermissible mode selection). If mode 3 or mode 4 are required, the engine must be switched off and the diagnostic subsequently repeated with initialisation.

d) Mode-internal arrangement:

The test steps within the individual modes cannot be selected; they occur in accordance with a specified sequence (the continuation within the sequence is controlled by means of individual logical "0" pulses).

Description of the individual modes:

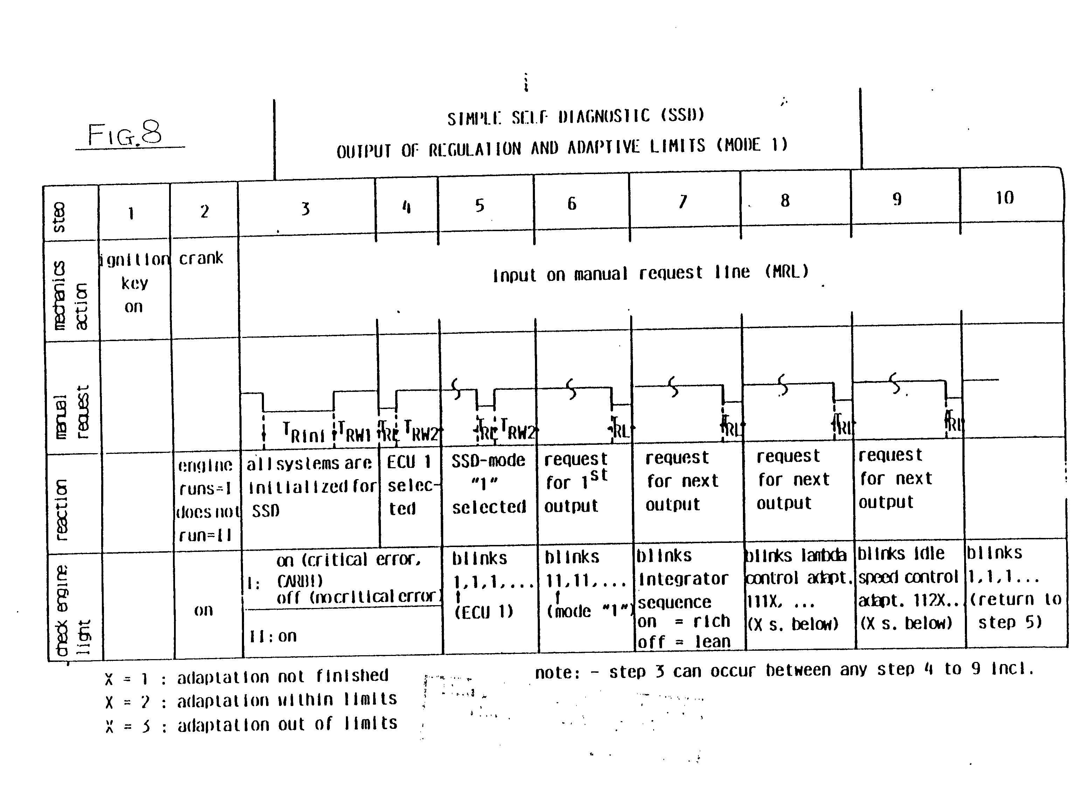

1) Mode 1: sequential checking and output (flashing code via the fault lamp) of the regulation and adaptation variables (see Fig. 8)

Example:

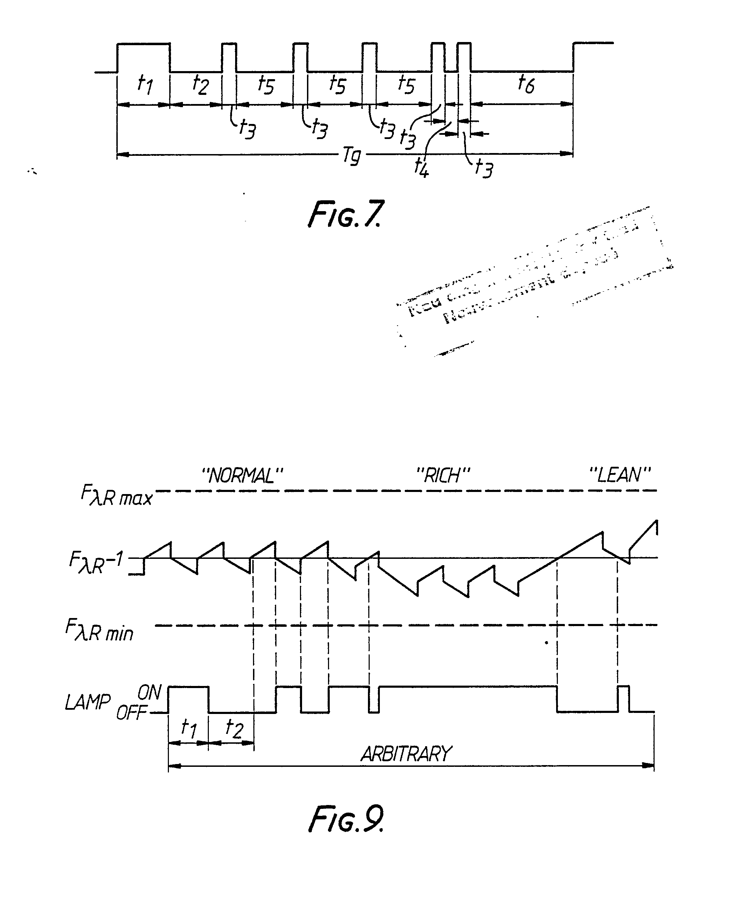

in the sequence
Flashing code I 1,
Flashing code I 1 1 1,
Flashing code output I 1 1 1 2 (see Fig. 7)
- I $\triangleq$ start of flashing code output
- 1 $\triangleq$ ECU No. 1
- 1 $\triangleq$ Mode 1
- 1 $\triangleq$ Adaptation variable 1
- 2 $\triangleq$ Adaptation value within specified limits
or 1 1 1 1 $\triangleq$ Adaptation not completed
or 1 1 1 3 $\triangleq$ Adaptation value out of range

In Fig. 7:

| $T_g$ | = | total cycle for one fault code showing the number 1 1 1 2 | |
|---|---|---|---|
| $t_1$ | = | start signal (beginning of the code) | approx. 2.5 sec |
| $t_2$ | = | interval before the first block | approx. 2.5 sec |
| $t_3$ | = | time of the flashing pulse | approx. 0.5 sec |
| $t_4$ | = | interval time between flashes of a block | approx. 0.5 sec |
| $t_5$ | = | time between blocks | approx. 2.5 sec |
| $t_6$ | = | interval to the second fault code indication | approx. 2.5 sec |

Nonconformal inputs (exceeding the time pattern and their consequences can be summarised as follows:
- logic "0" > 1.0 sec. → jump to sequence start/flashing code B

- logic "1" < 0.3 sec. → not recognised/flashing code unchanged
- logic "0" > 2.0 sec. → initialisation/fault lamp off

If a new request occurs after the output of the last adaptation variable (logic "0" pulse input), the fault lamp signals with flashing code A and a new mode selection can follow.

Exception:

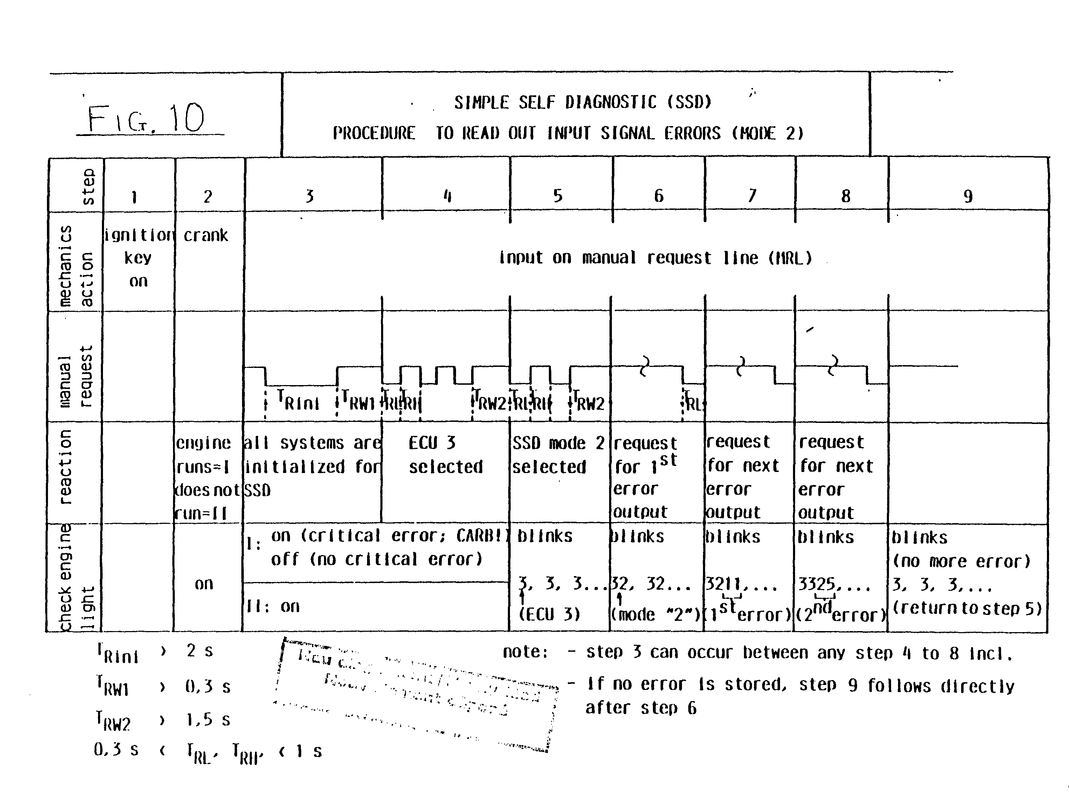

The $\lambda$ regulation will occupy 2 steps in the mode 1 sequence which immediately follow behind one another; with the first logic "0" pulse, a nonconformal flashing code output occurs (see Fig. 8 and Fig. 9) and with the next one the mode-1-specific output (see Fig. 7 for example).

Note:

it is possible to omit the nonconformal integrator sequence if there is a risk of wrong interpretation.

1) Mode 2: sequential calling and output of the faults stored - during the drive - in the fault memory (permanent RAM) within the range:

- sensor inputs, checked in accordance with plausibility criteria with provision of equivalent variables
- ECU (watchdog, RAM, ROM, etc.)
(see Fig. 10)
in the sequence
Flashing code I3,
Flashing code I32,

Example:

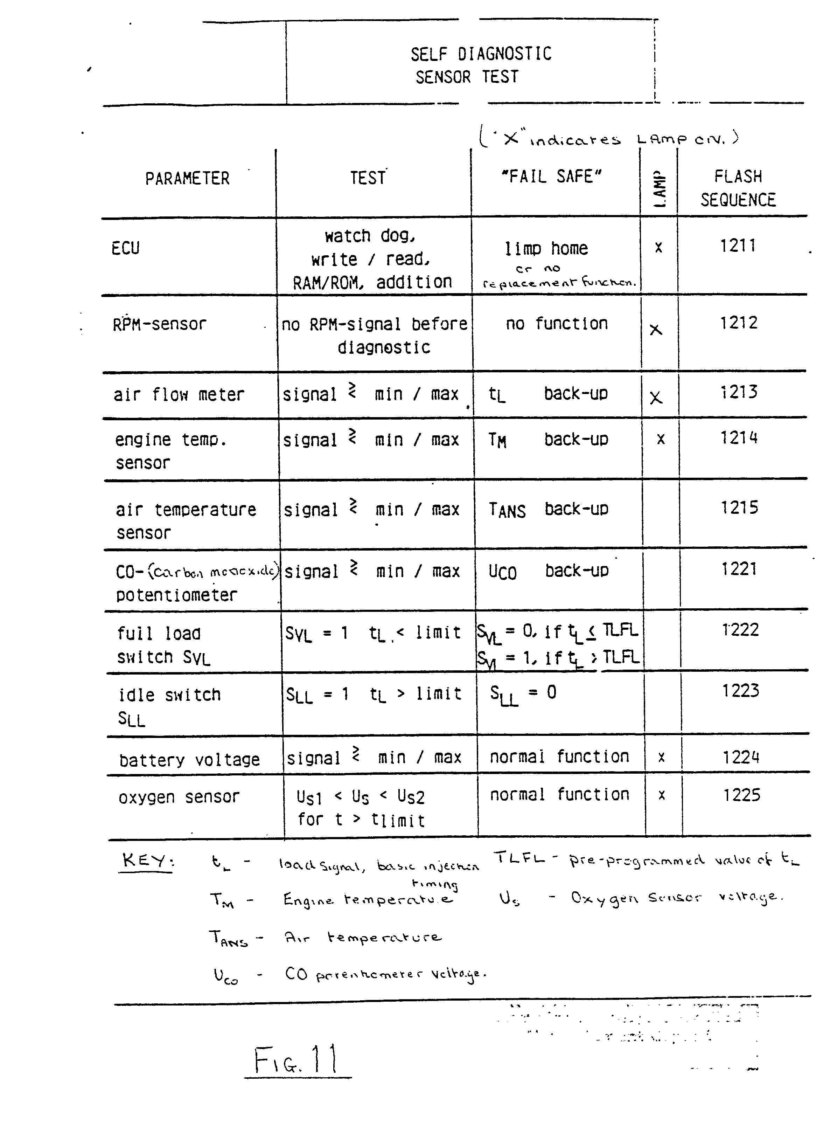

Flashing code output I 3 2 1 2 (see Fig. 6, flashing code D).
- I ≙ start of flashing code output
- 3 ≙ ECU No. 3
- 2 ≙ Mode 2
- 12 ≙ rpm sensor (see Fig. 11)
(the fault memory size must be dimensioned in accordance with the ECU)

Note:

A single logic "0" pulse within the mode-2 sequence causes a jump to the next sequence occupied (fault present) and not simply to the next cell of the fault memory.

Nonconformal inputs have the same effect as in Mode 1. If there is no fault or there is a new request (logic "0" pulse input) after the output of the last fault, acknowledgement occurs with flashing code I3 via the fault lamp.

With the next engine start-up (n > LIMIT) the fault memory cells set whose specific disturbance sources have been eliminated are erased.

Figure 11 is a table explaining the sensor test in more detail. The flashing sequences shown are for ECU No. 1 in mode 2. The test itself depends on what is being examined, e.g. ECU or engine temperature sensor. If one of the sensors listed in the first column becomes defective this is sensed during running of the engine and, where necessary, a "fail-safe" function is provided so that the engine can continue to run. For example, if the air temperature sensor is found to be defective a back-up air temperature signal is provided because the actual air temperature signal is not longer available. If an ECU fails a "limp home" program may need to be provided, depending on which ECU has failed. For certain sensors it is not necessary to provide a "fail safe" function. For example, if the battery voltage becomes too low the only problem aris ing from this is that the engine may be difficult to start again. The driver is simply warned about this through illumination of the lamp.

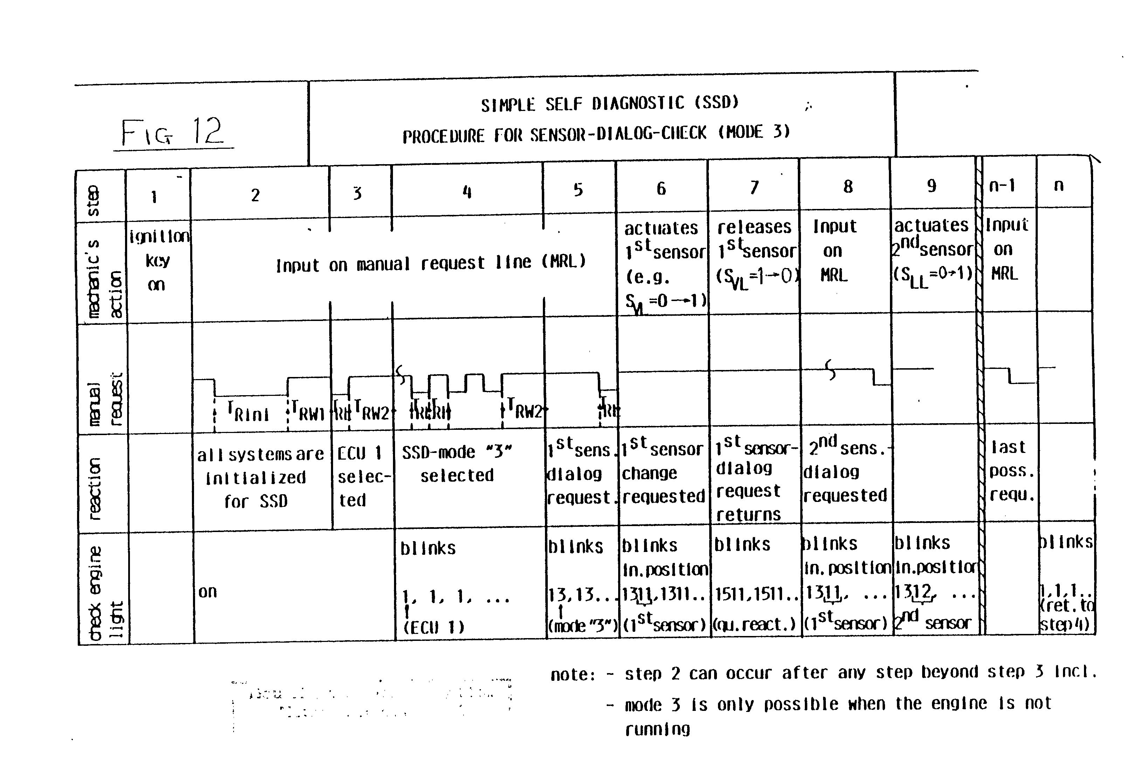

3) Mode 3: Sequential interactive checking and output of the digital inputs (engine stand-still assumed). See Fig. 12.

Example:

in the sequence
Flashing code I 1,
Flashing code I 1 3,
Flashing code I 1 3 1 1,
digital input No. 11 of ECU No.1 is called up in mode 3 in its initial position (e.g. S__ VL (full load switch) = 0 or open).

The operator is then requested to bring the digital input No. 11 into its complementary position (actuate gas pedal so that the mechanical end position is reached); if ECU No. 1 signals with
Flashing code I 1 5 1 1,
via the fault lamp, digital input No. 11 operation is correct. If the switch is returned to its rest position, the output changes back to
Flashing code I 1 3 1 1.
This can be repeated.


Mode 4: Sequential actuation of the actuators which can be manually called up.


Example:

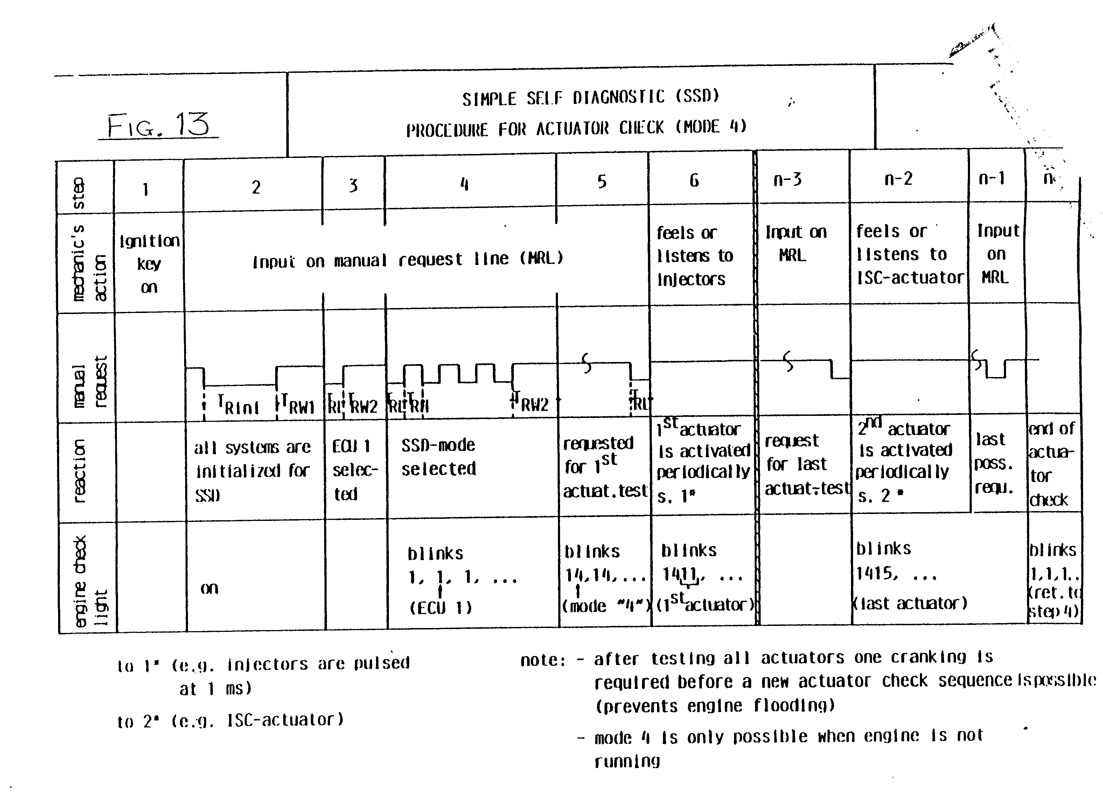

in the sequence:
Flashing code I 1,
Flashing code I 14,
Flashing code I 1 4 1 1,
the actuator with address 11, associated withEcu No. 1, is selected and simultaneously actuated in the flashing code pulse sequence which enables the operator to observe its correct function in a direct (visual, acoustical) manner (see Fig. 13).

The simple selfdiagnostic can be interrupted at any time by switching off the ignition.


Supplements to the specifications

The above specifications for the selfdiagnostic are supplemented by ECU or customer-specific specifications which should contain the following data:
- Number, type, accurate definition of signals which can be diagnosed; monitoring criteria and type of equivalent variables which can be made available.
- Number of combined ECUs and of modes
- Specification of the L and/or K line and of the input. If this is not possible, the valid (software) recognition combination for initiation of diagnostic
- Definition of specific flashing code
- Type and size of the fault memory
It is also to be noted that the ECU, once it has been manually addressed, transmits the flashing codes at a rate much less than would be the case were a tester to be used. The rate used may be different depending on whether the visual display is a lamp for repeating the codes or a digital display which receives the codes and decodes them to a decimal number.


**Claims**

1. An electronic system for controlling the operation of a vehicle including at least one electronic control unit (ECU) connected to at least one actuator or sensor, the system being arranged to carry out a plurality of tests for indicating faults in parts of the system, characterised by manually operable switch means for providing a signal indicative of a requested test and visual display means for providing a visual indication to confirm the test requested.

2. A system as claimed in claim 1 including a plurality of electronic control units each connected to said visual display means and to at least one actuator or sensor and each arranged to operate in at least one mode for detecting a fault within the unit and/or said at least one actuator or sensor, in which said switch means is operable to address a desired ECU and the visual display means is activated by the selected ECU to confirm that it has been selected.

3. A system as claimed in claim 1 or 2, in which the or each ECU is arranged to operate in a plurality of operating modes for detecting a fault within the unit and/or said at least one actuator or sensor, said switch means is operable to select a particular operating mode and the visual display means is activated to indicate which operating mode has been selected.

4. A system as claimed in claim 2 or 3, in which the or each test includes a plurality of stages and the visual display means is arranged to indicate the progress of the requested test.

5. A system as claimed in claim 4 in which the visual display means further indicates one or more steps to be carried out by the operator to enable the continuation of the requested test.

6. A system as claimed in any preceding claim in which the visual display means comprises a lamp arranged to flash in a coded sequence indicative of the selected test.

7. A system as claimed in claim 6 including more than one ECU, each ECU being provided with a separate lamp.

8. A system as claimed in any of claims 1 to 5, in which the visual display means is a digital display.

9. A system as claimed in any preceding claim in which the visual display means is arranged to indicate the presence of certain faults during running of the engine while no test is being carried out.

Fig.1.

Fig.2.

F1 — ENGINE CHECK-LIGHT

L-OR K-BUS

ECU1

ECU2

TESTER

Fn

ECUn

SW1 — MANUAL REQUEST FOR SIMPLIFIED SELF-DIAGNOSTIC

FIG.3.

START SIMPLE
SELFDIAGNOSTIC

INITIALIZE

ECU  SELECTION

>F

MODE  SELECTION

>4

MODE/INTERNAL  ARRANGEMENT

SEQUENCE START

SEQUENCE END

———— CONFORMAL  INPUT

- - - - - NONCONFORMAL  INPUT (EXCEEDING TIME PATTERN)
SIMPLE  SELFDIAGNOSTIC/HIERARCHY

FIG.4.

FIG.5.

FAULT LAMP
ON
OFF

- FLASHING CODE A : I 3

ON
OFF

- FLASHING CODE B : I 3 2

ON
OFF

- FLASHING CODE C : I 3 6    (MODE 3 OR 4 SELECTED WITH ENGINE RUNNING)

ON
OFF

$t_1$   $t_2$   $t_3$ $t_4$ $t_3$ $t_4$ $t_3$   $t_5$   $t_3$ $t_4$ $t_3$   $t_5$   $t_3$   $t_5$   $t_3$ $t_4$ $t_3$   $t_6$

I       3                  2           1           2

- FLASHING CODE D : I 3 2 1 2

*Fig.6.*

EP 0 353 331 A1

FIG.7.

FIG.9.

**FIG.8**

### SIMPLE SELF DIAGNOSTIC (SSD)
### OUTPUT OF REGULATION AND ADAPTIVE LIMITS (MODE 1)

| step | 1 | 2 | 3 | 4 | 5 | 6 | 7 | 8 | 9 | 10 |
|---|---|---|---|---|---|---|---|---|---|---|
| mechanics action | ignition key on | crank | Input on manual request line (MRL) | | | | | | | |
| manual request | | | $T_{Rini}$ $T_{RW1}$ $T_{RE}$ $T_{RW2}$ | | $T_{RE}$ $T_{RW2}$ | RL | RL | RL | RL | RL |
| reaction | | engine runs=I does not run=II | all systems are initialized for SSD | ECU 1 selected | SSD-mode "1" selected | request for 1st output | request for next output | request for next output | request for next output | |
| check engine light | | on | on (critical error, I: CARB!) off (no critical error) II: on | | blinks 1,1,1,... (ECU 1) | blinks 11,11,... (mode "1") | blinks integrator sequence on = rich off = lean | blinks lambda control adapt. 111X, ... (X s. below) | blinks idle speed control adapt. 112X.. (X s. below) | blinks 1,1,1... (return to step 5) |

X = 1 : adaptation not finished
X = 2 : adaptation within limits
X = 3 : adaptation out of limits

note: – step 3 can occur between any step 4 to 9 incl.

# FIG. 10

## SIMPLE SELF DIAGNOSTIC (SSD)
### PROCEDURE TO READ OUT INPUT SIGNAL ERRORS (MODE 2)

| step | 1 | 2 | 3 | 4 | 5 | 6 | 7 | 8 | 9 |
|---|---|---|---|---|---|---|---|---|---|
| mechanics action | ignition key on | crank | input on manual request line (MRL) | | | | | | |
| manual request | | | $T_{Rini}$ $T_{RW1}$ $T_{RL}$ $T_{RH}$ | $T_{RW2}$ $T_{RL}$ $T_{RH}$ $T_{RW2}$ | | $T_{RL}$ | | | |
| reaction | | engine runs=I does not run=II | all systems are initialized for SSD | ECU 3 selected | SSD mode 2 selected | request for 1st error output | request for next error output | request for next error output | |
| check engine light | | on | I: on (critical error; CARB!) off (no critical error) / II: on | blinks 3, 3, 3... (ECU 3) | blinks 32, 32... (mode "2") | blinks 3211,... (1st error) | blinks 3325,... (2nd error) | blinks (no more error) 3, 3, 3,... (return to step 5) |

$T_{Rini}$ ⟩ 2 s

$T_{RW1}$ ⟩ 0,3 s

$T_{RW2}$ ⟩ 1,5 s

0,3 s ⟨ $T_{RL}$, $T_{RH}$ ⟨ 1 s

note: — step 3 can occur between any step 4 to 8 incl.

— If no error is stored, step 9 follows directly after step 6

EP 0 353 331 A1

| | SELF DIAGNOSTIC SENSOR TEST | | | |

("X" indicates LAMP on.)

| PARAMETER | TEST | "FAIL SAFE" | LAMP | FLASH SEQUENCE |
|---|---|---|---|---|
| ECU | watch dog, write / read, RAM/ROM, addition | limp home or no replacement function. | x | 1211 |
| RPM-sensor | no RPM-signal before diagnostic | no function | x | 1212 |
| air flow meter | signal $\gtrless$ min / max | $t_L$ back-up | x | 1213 |
| engine temp. sensor | signal $\gtrless$ min / max | $T_M$ back-up | x | 1214 |
| air temperature sensor | signal $\gtrless$ min / max | $T_{ANS}$ back-up | | 1215 |
| CO- (carbon monoxide) potentiometer | signal $\gtrless$ min / max | $U_{CO}$ back-up | | 1221 |
| full load switch $S_{VL}$ | $S_{VL} = 1$ $t_L < $ limit | $S_{VL} = 0$, if $t_L \leq TLFL$ $S_{VL} = 1$, if $t_L > TLFL$ | | 1222 |
| idle switch $S_{LL}$ | $S_{LL} = 1$ $t_L > $ limit | $S_{LL} = 0$ | | 1223 |
| battery voltage | signal $\gtrless$ min / max | normal function | x | 1224 |
| oxygen sensor | $U_{S1} < U_S < U_{S2}$ for $t > t_{limit}$ | normal function | x | 1225 |

KEY:  $t_L$ - load signal, basic injection timing      TLFL - pre-programmed value of $t_L$

$T_M$ - Engine temperature      $U_S$ - Oxygen sensor voltage.

$T_{ANS}$ - Air temperature

$U_{CO}$ - CO potentiometer voltage.

Fig. 11

# FIG 12

## SIMPLE SELF DIAGNOSTIC (SSD) PROCEDURE FOR SENSOR-DIALOG-CHECK (MODE 3)

| step | 1 | 2 | 3 | 4 | 5 | 6 | 7 | 8 | 9 | n-1 | n |
|---|---|---|---|---|---|---|---|---|---|---|---|
| mechanic's action | ignition key on | Input on manual request line (MRL) | | | | actuates 1st sensor (e.g. $S_{VL}=0\to1$) | releases 1st sensor ($S_{VL}=1\to0$) | Input on MRL | actuates 2nd sensor ($S_{LL}=0\to1$) | Input on MRL | |
| manual request | | $T_{Rini}$  $T_{RW1}$  RH  $T_{RW2}$  RH RH  $T_{RW2}$  RH | | | | | | | | | |
| reaction | | all systems are initialized for SSD | ECU 1 selected | SSD-mode "3" selected | 1st sens. dialog request | 1st sensor change requested | 1st sensor-dialog request returns | 2nd sens. dialog requested | | last poss. requ. | |
| check engine light | | on | | blinks 1, 1, 1, ... (ECU 1) | blinks 13,13.. (mode "3") | blinks in.position 1311,1311.. (1st sensor) | blinks 1511,1511.. (qu.react.) | blinks in.position 1311, ... (1st sensor) | blinks in.position 1312, ... 2nd sensor | | blinks 1,1,1.. (ret. to step 4) |

note: – step 2 can occur after any step beyond step 3 incl.

– mode 3 is only possible when the engine is not running

EP 0 353 331 A1

## FIG. 13 — SIMPLE SELF DIAGNOSTIC (SSD) PROCEDURE FOR ACTUATOR CHECK (MODE 4)

| step | 1 | 2 | 3 | 4 | 5 | 6 | n-3 | n-2 | n-1 | n |
|---|---|---|---|---|---|---|---|---|---|---|
| mechanic's action | Ignition key on | Input on manual request line (MRL) | | | | feels or listens to injectors | Input on MRL | feels or listens to ISC-actuator | Input on MRL | |
| manual request | | $T_{Rini}$ $T_{RW1}$ | Rl $T_{RW2}$ | Rl TRl $T_{RW2}$ | TRl | | | | TRl | |
| reaction | | all systems are initialized for SSD | ECU 1 selec-ted | SSD-mode selected | requested for 1st actuat.test | 1st actuator is activated periodically s. 1* | request for last actuat.test | 2nd actuator is activated periodically s. 2 * | last poss. requ. | end of actua-tor check |
| engine check light | | on | | blinks 1, 1, 1, ... (ECU 1) | blinks 14,14,... (mode "4") | blinks 1411, ... (1st actuator) | | blinks 1415, ... (last actuator) | | blinks 1,1,1.. (ret. to step 4) |

to 1* (e.g. injectors are pulsed at 1 ms)

to 2* (e.g. ISC-actuator)

note: - after testing all actuators one cranking is required before a new actuator check sequence is possible (prevents engine flooding)

- mode 4 is only possible when engine is not running

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-A-3 540 599 (PORSCHE) * Abstract; claims; column 4, line 48 - column 6, line 11, line 64 - column 8, line 10; figures * | 1-5,8,9 | G 07 C 5/10 G 01 R 31/00 |
| A | | 6,7 | |
| X | DE-A-3 440 555 (BOSCH) * Abstract; claims; figures * | 1-4,6 | |
| A | | 7 | |
| X | EP-A-0 072 000 (TOYOTA et al.) * Abstract; page 2, line 19 - page 4, line 22; page 7, line 4 - page 14, line 17; claims; figures * | 1,3,8,9 | |
| A | | 2,4,5 | |
| Y | EP-A-0 231 607 (ZALESKI) * Column 4, line 52 - column 9, line 15; claims; figures * | 1-4,6 | |
| A | | 5,8,9 | TECHNICAL FIELDS SEARCHED (Int. Cl.4) |
| Y | WO-A-8 601 620 (BOSCH) * Abstract; page 3, line 21 - page 6, line 26; claims; figures * | 1-4,6 | G 07 C G 01 R |
| A | | 7-9 | |
| A | WO-A-8 802 122 (FIAT) * Abstract; claims; figures * | 1-3 | |

The present search report has been drawn up for all claims

| Place of search | Date of completion of the search | Examiner |
|---|---|---|
| THE HAGUE | 05-04-1989 | MEYL D. |

EPO FORM 1503 03.82 (P0401)